# EUROPEAN PATENT APPLICATION

(11) **EP 2 848 861 A1**
(43) Date of publication of application: **18.03.2015**
(21) Application number: 13812889.7
(22) Date of filing: 25.02.2013
(51) Int. Cl.: F21V 9/08, F21S 2/00

(54) **ILLUMINATION DEVICE**

(30) Priority: 02.07.2012 KR 20120071650
(71) Applicant: LG Innotek Co., Ltd., Seoul 100-714 (KR)
(72) Inventor: KIM, Young Jin, Seoul 100-714 (KR); KIM, Bo Ram, Seoul 100-714 (KR); SON, Eon Ho, Seoul 100-714 (KR)
(74) Representative: Cabinet Plasseraud
(86) International application number: PCT/KR2013/001479
(87) International publication number: WO 2014/007451

(57) **Abstract**

A lighting device may be provided that includes: a light emitting device; and a phosphor composition which is disposed on the light emitting device. The phosphor composition includes phosphor and glass frit. The phosphor includes yellow phosphor and red phosphor. A ratio of the yellow phosphor and the red phosphor is from 6:1 to 10:1.

## Description

### [Technical Field]

Embodiments may relate to a lighting device.

### [Background Art]

A light emitting diode has higher efficiency, a longer lifespan and is smaller than an incandescent bulb.

Recently, a white LED module (or package) is being widely spread is used for lighting.

The white LED module (or package) may be created, for example, by using a blue LED chip and a phosphor composition.

A conventional phosphor composition is generally formed by mixing a powdered phosphor with liquid silicone and then by curing it. Such a conventional phosphor composition is greatly vulnerable to heat, and thus is transformed by the heat and turns yellow. In particular, in a condition that lighting having a high luminous flux (larger than about 2000 lm) is recently released, there is an urgent necessity of a phosphor composition which is able to endure high temperature.

Also, since the conventional phosphor composition has its small hardness, a structure has been required which allows the phosphor composition to be well coated thereon or well adhered thereto. Such a structure degrades the optical efficiency of a lighting device.

### [Disclosure]

### [Technical Problem]

The embodiment of the present invention provides a lighting device including phosphor composition capable of enduring high temperature.

The embodiment of the present invention provides the lighting device including phosphor composition having a large hardness.

The embodiment of the present invention provides the lighting device which is able to emit light with high luminous flux.

The embodiment of the present invention provides the lighting device which is able to increase luminous flux.

### [Technical Solution]

A lighting device according to an embodiment of the present invention includes: a light emitting device; and a phosphor composition which is disposed on the light emitting device. The phosphor composition includes phosphor and glass frit. The phosphor includes yellow phosphor and red phosphor. A ratio of the yellow phosphor and the red phosphor is from 6:1 to 10:1.

The phosphor composition may further include a filler.

The filler may further include at least any one of TiO₂, ZnO, MgO, Fe₂O₃, Ca.Mg.Silicate, Al₂O₃, Mgo.8Sio2.9H2O, Al₂O₃.2SiO₂.2H₂O, carbon black (C), graphite (C), MoS₂, BaSO₄ and CaSO₄.

The yellow phosphor may emit excited light having a peak wavelength of 530 nm to 560 nm. The red phosphor may emit excited light having a peak wavelength of 630 nm to 650 nm.

The phosphor may further include green phosphor.

The lighting device may further include a heat sink on which the light emitting device is disposed; and a reflector which reflects light emitted from the light emitting device toward the phosphor composition and is coupled to the heat sink.

The light emitting device may be disposed apart from the phosphor composition at a predetermined interval.

A lighting device according to another embodiment of the present invention includes: a light emitting device; and a phosphor composition which is disposed above the light emitting device, The phosphor composition includes phosphor and glass frit, In terms of weight percent (wt%), the phosphor composition includes 80 to 90 wt% of the phosphor and 10 to 20 wt% of the glass frit.

The phosphor composition may further include a filler.

The filler may include at least any one of TiO₂, ZnO, MgO, Fe₂O₃, Ca.Mg.Silicate, Al₂O₃, Mgo.8Sio2.9H2O, Al₂O₃.2SiO₂.2H₂O, carbon black (C), graphite (C), MoS₂, BaSO₄ and CaSO₄.

The lighting device may further include: a heat sink on which the light emitting device is disposed; and a reflector which reflects light emitted from the light emitting device toward the phosphor composition and is coupled to the heat sink.

The light emitting device may be disposed apart from the phosphor composition at a predetermined interval.

### [Advantageous Effects]

The lighting device according to the embodiment is able to endure high temperature.

The lighting device according to the embodiment is made of phosphor composition having a large hardness, and thus, is resistant to external impact.

The lighting device according to the embodiment is able to emit light with high luminous flux.

The lighting device according to the embodiment is able to increase luminous flux.

### [Description of Drawings]

Fig. 1 is a cross sectional view of a lighting device according to an embodiment of the present embodiment;
Figs. 2 to 4 are views for describing a manufacturing method of a phosphor composition shown in Fig. 1;
Fig. 5 is a cross sectional view of a lighting device according to another embodiment of the present embodiment; and
Fig. 6 is a cross sectional view of a lighting device according to further another embodiment of the present embodiment.

### [Mode for Invention]

Hereafter, an embodiment of the present invention will be described in detail with reference to accompanying drawings. However, the accompanied drawings are provided only for more easily describing the present invention. It is easily understood by those skilled in the art that the spirit and scope of the present invention is not limited to the scope of the accompanied drawings.

A criterion for "on" and "under" of each layer will be described based on the drawings.

A thickness or a size of each layer may be magnified, omitted or schematically shown for the purpose of convenience and clearness of description. The size of each component may not necessarily mean its actual size.

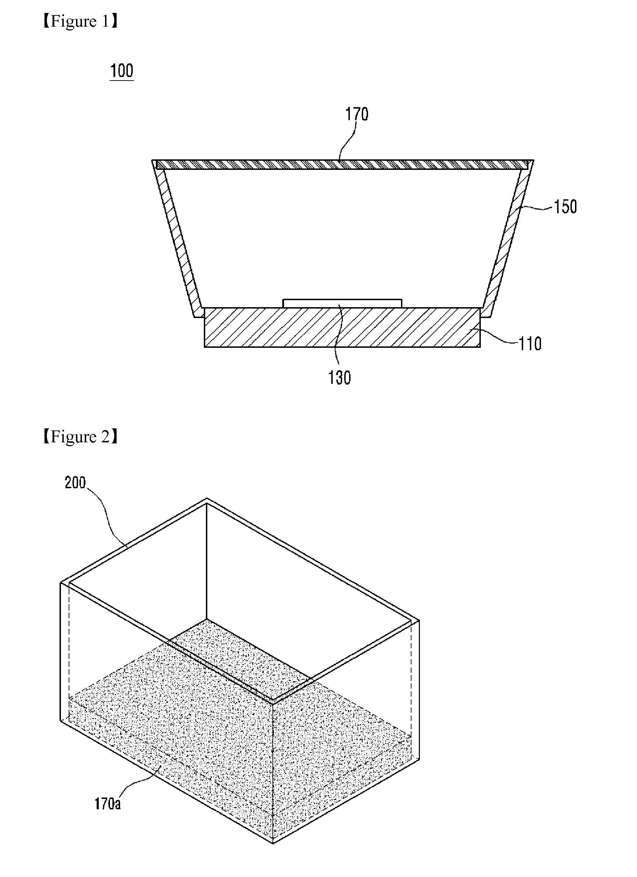

Fig. 1 is a cross sectional view of a lighting device according to an embodiment of the present embodiment.

Referring to Fig. 1, a lighting device 100 according to the embodiment may include a heat sink 110, a light source 130, a reflector 150 and a phosphor composition 170.

The heat sink 110 may receive heat radiated from the light source 130 and then may emit the heat. Specifically, the heat sink 110 may be made of a metallic material or a resin material which has excellent heat radiation efficiency. The heat sink 110 may be made of a material having high thermal conductivity (generally greater than 150 Wm⁻¹K⁻¹ and more preferably greater than 200 Wm⁻¹K⁻¹). For example, the material of the heat sink 110 may include copper (thermal conductivity greater than about 400 Wm⁻¹K⁻¹ and aluminum (thermal conductivity greater than about 250 Wm⁻¹K⁻¹), anodized aluminum, an aluminum alloy and a magnesium alloy. Further, the material of the heat sink 110 may include a metal loaded plastic material such as polymer, for example, epoxy or a thermally conductive ceramic material (e.g., aluminum silicon carbide (AlSiC) (thermal conductivity of about 170 to 200 Wm⁻¹K⁻¹).

The heat sink 110 may have one side on which the light source 130 is disposed. Here, the one side may be flat or curved at a predetermined curvature.

The heat sink 110 may be coupled to the reflector 150. Specifically, the outer portion of the heat sink 110 may be coupled to the lower portion of the reflector 150.

The heat sink 110 may include a plurality of heat radiating fins (not shown). The heat radiating fin (not shown) may project or extend outwardly from one side of the heat sink 110. The heat radiating fin (not shown) increases of a heat radiating area of the heat sink 110, thereby improving heat radiation efficiency.

The light source 130 is disposed on the heat sink 110. Specifically, the light source 130 may be disposed on one side of the heat sink 110. The light source 130 may emit predetermined light onto the heat sink 110.

The light source 130 may be a light emitting device emitting predetermined light. Specifically, the light emitting device 130 may be any one of a blue light emitting device, a green light emitting device, a red light emitting device and a white light emitting device.

Also, the light emitting device 130 may be a light emitting diode (LED) chip. The LED chip 130 may be any one of a blue LED chip emitting blue light in a visible light spectrum, a green LED chip emitting green light in a visible light spectrum and a red LED chip emitting red light in a visible light spectrum. Here, the blue LED chip has a peak wavelength of from about 430 nm to 480 nm. The green LED chip has a peak wavelength of from about 510 nm to 535 nm. The red LED chip has a peak wavelength of from about 600 nm to 630 nm.

A plurality of the light emitting devices 130 may be disposed. A plurality of the light emitting devices 130 may emit lights having the same wavelength or may emit lights having mutually different wavelengths. Also, a plurality of the light emitting devices 130 may emit lights having the same color or may emit lights having mutually different colors.

The reflector 150 reflects the light from the light source 130 toward the phosphor composition 170 and supports the phosphor composition 170 above the light source 130. The reflector 150 may surround the light source 130 and may be coupled to the heat sink 110.

The reflector 150 may have a reflective surface reflecting the light emitted from the light source 130. The reflective surface may be substantially perpendicular to or at an obtuse angle to one side of the heat sink 110. The reflective surface may be coated or deposited with a material capable of easily reflecting the light.

Meanwhile, the heat sink 110 and reflector 150 may be integrally formed with each other. In this case, they may form one chamber.

The phosphor composition 170 may be disposed above the light source 130 and may be disposed on the reflector 150. The outer portion of the phosphor composition 170 may be coupled to the upper portion of the reflector 150. The reflector 150 causes the phosphor composition 170 to be disposed apart from the light source 130 at a predetermined interval.

The phosphor composition 170 may light excited by the light emitted from the light source 130. Specifically, when the light emitted from the light source 130 is incident on the phosphor composition 170, the phosphor composition 170 may allow a part of the incident light to pass therethrough as it is and may emit the light excited by the other part of the incident light. Therefore, the phosphor composition 170 may emit light mixed with the excited light and the light emitted from the light source 130. Accordingly, the light emitted from the phosphor composition 170 may be recognized as white light by an observer.

The phosphor composition 170 may include phosphor and glass frit.

The phosphor is in the form of powder. The phosphor may be at least one of yellow, green, red phosphors. More specifically, the phosphor may include the yellow and red phosphors.

The yellow phosphor is excited by the light which has a wavelength of less than 500 nm and is emitted from the light source 130, and then emits light having a peak wavelength of 530 nm to 560 nm. The yellow phosphor may be a silicate phosphor, a garnet (YAG) phosphor and an oxynitride phosphor. The yellow phosphor may be selected from Y3Al5O12:Ce3+(Ce:YAG), CaAlSiN3:Ce3+ and Eu2+-SiAlON phosphors and/or may be selected from BOSE phosphor. The yellow phosphor may be doped at an arbitrary appropriate level so as to provide light output of a desired wavelength. Ce and/or Eu may be doped in the phosphor at a dopant concentration of about 0.1 % to about 20 %. A phosphor appropriate for this purpose may include products produced by Mitsubishi Chemical Company (Tokyo, Japan), Leuchtstoffwerk Breitungen GmbH(Breitungen, Germany) and Intermatix Company (Fremont, California).

The red phosphor is excited by the light which has a wavelength of less than 580 nm and is emitted from the light source 130, and then emits light having a peak wavelength of 630 nm to 650 nm. The red phosphor may be a nitride phosphor and a sulfide phosphor. The red phosphor may include CaAlSiN3:Eu2+ and Sr2Si5N8:Eu2+. These phosphors can cause a quantum efficiency to be maintained greater than 80 % at a temperature higher than 150 °C. Another usable red phosphor may be selected from not only CaSiN2:Ce3+ and CaSiN2:Eu2+ but Eu2+-SiAlON phosphor and/or may be selected from (Ca,Si,Ba)SiO4:Eu2+(BOSE) phosphor. Particularly, a CaAlSiN:Eu2+ phosphor of the Mitsubishi Chemical Company may have a dominant wavelength of about 624 nm, a peak wavelength of about 628 nm and FWHM of about 100 nm.

Here, the phosphor of the phosphor composition 170 may be formed by a mixture of the yellow phosphor and the red phosphor in a predetermined ratio. Specifically, in the phosphor composition 170, a ratio of the yellow phosphor and the red phosphor may be from 6:1 to 10:1. When the ratio of the yellow phosphor and the red phosphor is from 6:1 to 10:1, the color temperature of the light emitted from the phosphor composition 170 may have a random value between warm white and cold white. That is, when the ratio of the yellow phosphor and the red phosphor is from 6:1 to 10:1, the lighting device according to the embodiment is able to emit the light having a white color temperature.

Meanwhile, the phosphor of the phosphor composition 170 may further include the green phosphor. Due to the included green phosphor, CRI of the light emitted from the phosphor composition 170 can be more improved.

The green phosphor is excited by the light which has a wavelength of less than 400 nm and is emitted from the light source 130, and then emits light having a peak wavelength of 450 nm to 530 nm. The green phosphor may be a silicate phosphor, a nitride phosphor and an oxynitride phosphor.

The glass frit included in the phosphor composition 170 may be defined as glass in the form of powder or may be defined as low melting point powdered glass for electronic materials, which has insulation and airtightness and has an excellent mechanical strength and an excellent chemical durability.

The glass frit may be a compound including at least one PbO, ZnO, BiO, SiO₂ and B₂O₃. Specifically, the glass frit may be comprised of 60 wt% of PbO and 30 wt% of SiO₂ or may be comprised of 30 wt% of SiO₂, 30 wt% of ZnO and 30 wt% of BiO, or may be comprised of 60 wt% of B₂O₃ and 30 wt% of PbO.

In terms of weight percent (wt%), the phosphor composition 170 may be comprised of 80 to 90 wt% of the phosphor and 10 to 20 wt% of the glass frit. When in terms of weight percent (wt%), the phosphor composition 170 is comprised of 80 to 90 wt% of the phosphor and 10 to 20 wt% of the glass frit, the phosphor composition 170 is able to endure high temperature and has a large hardness. Therefore, the phosphor composition 170 does not turn yellow and has no problem in its transmiitance even though light having a high luminous flux (larger than about 2000 lm) is emitted from the light source 130.

The phosphor composition 170 may further include a filler. Here, the filler may be a ceramic filler. Also, the filler may be one or more of TiO₂, ZnO, MgO, Fe₂O₃, Ca.Mg.Silicate, Al₂O₃, Mgo.8Sio2.9H2O, Al₂O₃.2SiO₂.2H₂O, carbon black (C), graphite (C), MoS₂, BaSO₄ and CaSO₄.

The luminous flux of the light emitted from the phosphor composition 170 can be more increased by adding the filler to the phosphor composition 170. The following table 1 provides experimental results showing this.

**Table 1**

| Sample | Lm (luminous flux) |
|---|---|
| Sample 1 | 100.00% |
| phosphor composition without filler | |
| Sample 2 | 101.14% |
| phosphor composition including TiO₂ | |
| Sample 3 | 100.87% |
| phosphor composition including ZnO | |

Referring to the above table 1, it can be seen that when the luminous flux of the sample 1 is 100, the luminous fluxes of the samples 2 and 3 are larger than 100. Accordingly, the phosphor composition including the filler can more increase the luminous flux than the phosphor composition without the filler.

Also, it can be found that TiO₂ as the filler has more influence on the luminous flux than ZnO.

Since the phosphor composition 170 of the lighting device according to the embodiment shown in Fig. 1 includes the glass frit, the phosphor composition 170 is able to endure high temperature and has a large hardness. Therefore, the phosphor composition 170 does not turn yellow and has no problem in its transmiitance even though light having a high luminous flux (larger than about 2000 lm) is emitted from the light source 130. Accordingly, the lighting device 100 including the phosphor composition 170 can emit the light having a high luminous flux.

Since the phosphor composition 170 shown in Fig. 1 may be disposed apart from the light source 130 at a predetermined interval, the phosphor composition 170 can be substituted for a conventional remote phosphor. While the conventional remote phosphor requires a structure which allows the remote phosphor to be coated thereon or adhered thereto, the lighting device according to the embodiment does not require a structure for fixing the phosphor composition due to the high hardness of the phosphor composition itself.

Hereafter, a method for manufacturing the phosphor composition 170 will be described with reference to Figs. 2 to 4.

Figs. 2 to 4 are views for describing the method for manufacturing a phosphor composition shown in Fig. 1.

First, as shown in Fig. 2, a previously produced mold 200 is provided. The mold 200 is a rectangular hexahedron with an empty interior. The rectangular hexahedron may have an open top surface.

A slurry 170a including the phosphor, the glass frit, the filler and an additive, all of which are mixed in a predetermined ratio is poured inside the mold 200.

The additive may be a binder or polymer poly vinyl butylal (PVB).

The binder is a kind of resin or cement. The particles of the binder are united to improve mechanical strength, homogeneous adhesion and solidification. The binder may further include a lubricant which reduces mechanical friction and facilitates sliding of the machine or further include a plastic material used for softening the binder itself.

The binder used for extrusion molding or compression molding is PVA, PVB, PEG, methyl cellulose and the like. It is recommended that the binder used in the manufacture of the phosphor composition according to the embodiment should be dissolved or dispersed in a solvent without being reacting with the glass frit and the phosphor and should be completely dissolved at a temperature of lower than 400 degree, and should have no residue after being dissolved and volatilized.

The amount of the added binder may be from 4 % to 10 % compared with the phosphor.

The additive may be any one of a solvent, plasticizer and dispersant

After the slurry 170a is poured into the mold 200, the mold 200 including the slurry 170a is plasticized. The detailed specific plasticizing process may be as follows. The additive is burned out at a temperature from 100 °C to 200 °C, and then the glass frit is sintered at a temperature from 300 °C to 600 °C.

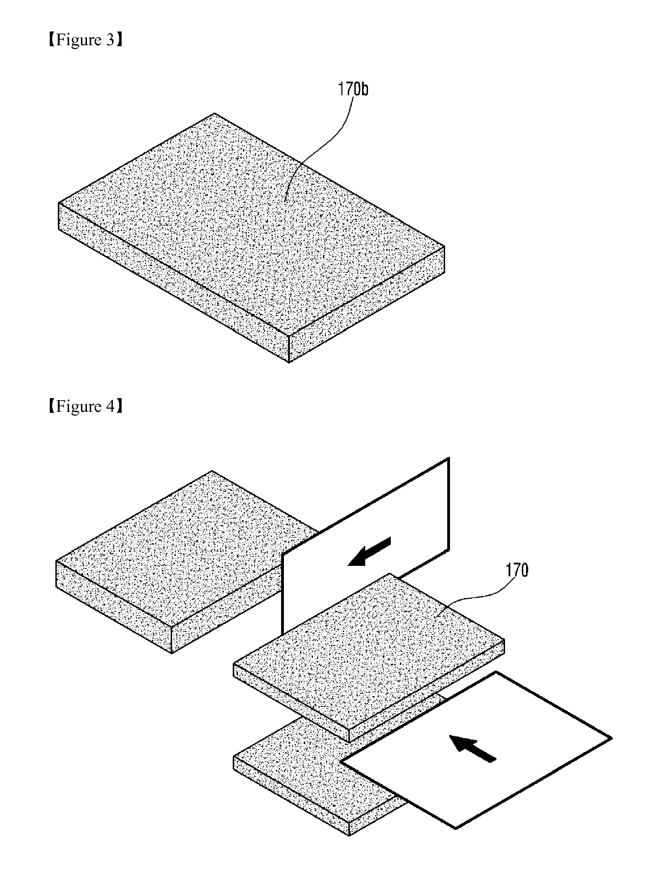

Then, the mold 200 is cooled. A cured phosphor composition 170b is obtained as shown in Fig. 3 by pulling out the phosphor composition 170 cured inside the cooled mold 200.

Lastly, as shown in Fig. 4, the cured phosphor composition 170b is cut horizontally or/and vertically as desired by a user, so that the phosphor composition 170 shown in Fig. 1 is obtained.

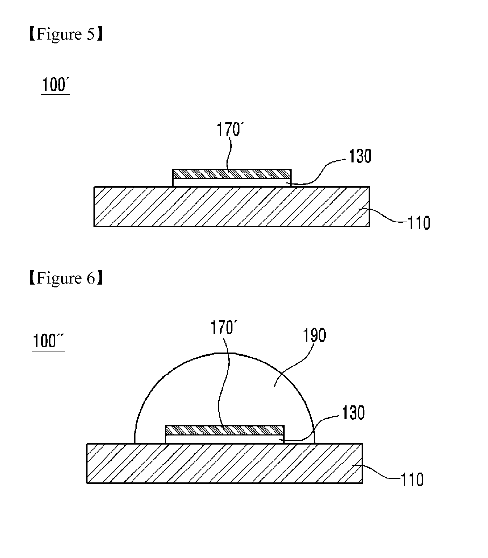

Fig. 5 is a cross sectional view of a lighting device according to another embodiment of the present embodiment.

A lighting device 100' according to another embodiment shown in Fig. 5 includes the heat sink 110, the light source 130 and a phosphor composition 170'.

Since the heat sink 110 and the light source 130 are the same as those of the lighting device 100 shown in Fig. 1, a detailed description thereof will be omitted.

While a material constituting the phosphor composition 170' is the same as the material constituting the phosphor composition 170 shown in Fig. 1, the position of the phosphor composition 170' is different from that of the phosphor composition 170 shown in Fig. 1. Specifically, the phosphor composition 170' is disposed contacting directly with the light emitting surface of the light source 130.

Fig. 6 is a cross sectional view of a lighting device according to further another embodiment of the present embodiment.
A lighting device 100" according to further another embodiment shown in Fig. 6 is obtained by adding a molding part 190 to the lighting device 100' according to the another embodiment shown in Fig. 5.

The molding part 190 covers the light source 130 and the phosphor composition 170' and is disposed on the heat sink 110. The molding part 190 may be formed of a resin material such as silicone. The molding part 190 is able to fix the phosphor composition 170' on the light source 130.

Although preferred embodiments of the present invention were described above, these are just examples and do not limit the present invention. Further, the present invention may be changed and modified in various ways, without departing from the essential features of the present invention, by those skilled in the art. For example, the components described in detail in the embodiments of the present invention may be modified. Further, differences due to the modification and application should be construed as being included in the scope and spirit of the present invention, which is described in the accompanying claims.

## Claims

1. A lighting device comprising:
a light emitting device; and
a phosphor composition which is disposed on the light emitting device,
wherein the phosphor composition comprises phosphor and glass frit, wherein the phosphor comprises yellow phosphor and red phosphor, and wherein a ratio of the yellow phosphor and the red phosphor is from 6:1 to 10:1.

2. The lighting device of claim 1, wherein the phosphor composition further comprises a filler.

3. The lighting device of claim 2, wherein filler further comprises at least any one of TiO₂, ZnO, MgO, Fe₂O₃, Ca.Mg.Silicate, Al₂O₃, Mgo.8Sio2.9H2O, Al₂O₃.2SiO₂.2H₂O, carbon black (C), graphite (C), MoS₂, BaSO₄ and CaSO₄.

4. The lighting device of claim 1, wherein the yellow phosphor emits excited light having a peak wavelength of 530 nm to 560 nm, and wherein the red phosphor emits excited light having a peak wavelength of 630 nm to 650 nm.

5. The lighting device of claim 1, wherein phosphor further comprises green phosphor.

6. The lighting device of claim 1, further comprising:
a heat sink on which the light emitting device is disposed; and
a reflector which reflects light emitted from the light emitting device toward the phosphor composition and is coupled to the heat sink.

7. The lighting device of claim 1, wherein the light emitting device is disposed apart from the phosphor composition at a predetermined interval.

8. A lighting device comprising:
a light emitting device; and
a phosphor composition which is disposed above the light emitting device,
wherein the phosphor composition comprises phosphor and glass frit. wherein, in terms of weight percent (wt%), and wherein the phosphor composition comprises 80 to 90 wt% of the phosphor and 10 to 20 wt% of the glass frit.

9. The lighting device of claim 8, wherein the phosphor composition further comprises a filler.

10. The lighting device of claim 9, wherein the filler comprises at least any one of TiO₂, ZnO, MgO, Fe₂O₃, Ca.Mg.Silicate, Al₂O₃, Mgo.8Sio2.9H2O, Al₂O₃.2SiO₂.2H₂O, carbon black (C), graphite (C), MoS₂, BaSO₄ and CaSO₄.

11. The lighting device of claim 8, further comprising:
a heat sink on which the light emitting device is disposed; and
a reflector which reflects light emitted from the light emitting device toward the phosphor composition and is coupled to the heat sink.

12. The lighting device of claim 8, wherein the light emitting device is disposed apart from the phosphor composition at a predetermined interval.
